# EUROPEAN PATENT APPLICATION

(11) **EP 1 403 986 A1**
(43) Date of publication of application: **31.03.2004**
(21) Application number: 02256674.9
(22) Date of filing: 25.09.2002
(51) Int. Cl.: H01S 5/12, H01S 5/34

(54) **Semiconductor laser device**

(71) Applicant: Agilent Technologies, Inc. - a Delaware corporation -, Palo Alto, CA 94303-0870 (US)
(72) Inventor: Ash, Richard Mark, Bury St. Edmunds, Suffolk IP33 2EZ (GB)
(74) Representative: Coker, David Graeme

(57) **Abstract**

Gain-coupled DFB lasers can be achieved by providing defect-migration mechanisms that enable the refractive index of the active layer of a DFB laser to be varied appropriately. In a first embodiment a material is implanted upon a buffer layer (330) and subsequently annealed, the annealing process causing the implanted material and defects caused by the implantation process to migrate into the active layer (320) to disorder the quantum well(s) therein. Appropriate patterning of the implantation will give rise to appropriate variation in refractive index. In a second embodiment, the buffer layer (430) is masked and the silica is sputtered onto the laser. Annealing of the laser causes point defects to migrate into the active layer (420) to disorder the quantum wells and cause the desired variation in refractive index.

## Description

This invention relates to semiconductor lasers and methods of producing such lasers and in particular to distributed feedback (DFB) semiconductor lasers and associated production methods.

DFB lasers are commonly used within optical telecommunications systems as they can provide an advantageous combination of high output power, narrow linewidth and the ability to be modulated at high transmission rates. There is a sub-class of DFB lasers, referred to as gain-coupled DFB lasers, in which the gain that is provided longitudinally along the laser cavity is modulated. This makes gain-coupled DFB lasers less susceptible to back-reflections that are generated within optical transmission networks (this may enable gain-coupled DFB lasers to be used in a module without an isolator, thus reducing the cost of the module) and also enables the lasers to be modulated at higher rates.

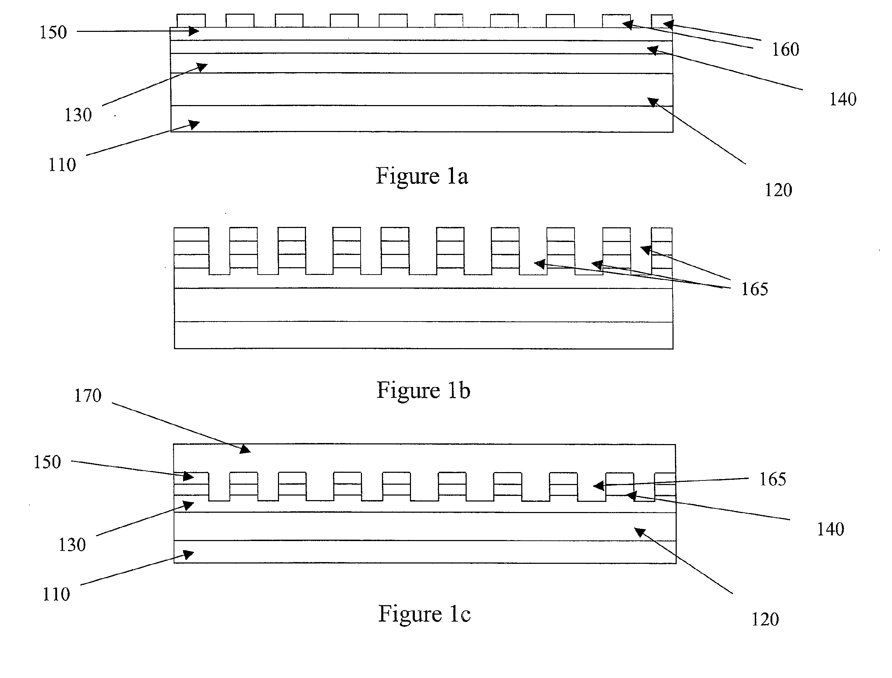

One known technique by which gain-coupled DFB lasers can be manufactured is to periodically form lossy material along the cavity to change the characteristics of the laser. Figure 1a shows an initial structure 100 which comprises first buffer layer 110, active layer 120, second buffer layer 130, lossy layer 140, capping layer 150 and photoresist regions 160. The layers are formed using conventional techniques and then the structure can be etched to form a plurality of wells 165 that extend through the capping layer 150, lossy layer 140 and part of the second buffer layer 120 (see Figure 1b). These wells can then be in-filled using standard overgrowth techniques to provide one or more further layers of semiconductor material 170. The in-filled wells form loss-coupled gratings that modulate the cavity gain to provide the desired laser performance. This technique has a number of associated disadvantages, including increased total cavity losses (which tend to degrade the overall performance of the laser) and the tendency of most lossy materials which are convenient for use in this application (e.g. a layer of lossy semiconductor) to become bleached at high power levels and increasing the probability that self pulsation will occur.

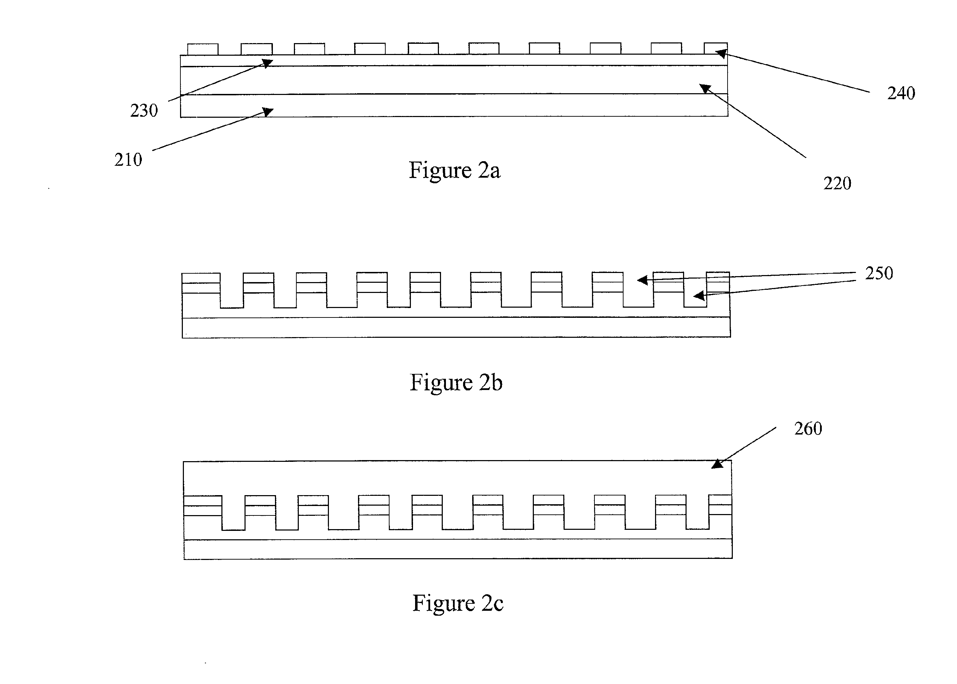

A further known technique involves etching into the active region of the laser to directly modify the amount of gain medium present. Figure 2a shows a structure 200 that comprises first buffer layer 210, active layer 220, capping layer 230 and photoresist regions 240. The structure is etched to form a plurality of wells 250 that extend into the active region of the laser (see Figure 2b). The wells are then in-filled and the laser structure covered with a waveguide overgrowth 260. The most significant disadvantage of this method is that the etching process is carried out within the active region of the laser. Control of the etch process to restrict the levels of damage and excess loss caused to an acceptable level is be expected to be very difficult to achieve.

According to a first aspect of the invention, there is provided a method of producing a semiconductor laser, the method comprising the steps of; (a) forming an active layer on a first buffer layer, the active layer comprising one or more quantum wells; (b) forming a second buffer layer on the active layer; the method being characterised by the following steps: (c) selectively applying an initiating material to the semiconductor laser, the application of the initiating material inducing a plurality of damage effects; and (d) processing the laser such that some of the initiating material or the damage effects migrate into the active layer so as to selectively modify the refractive index of the active layer. Preferably, during step (d) the migration of the initiating material or the damage effects modifies the refractive index of the active layer by disordering the one or more quantum wells.

In a first embodiment of the present invention, step (c) comprises selectively implanting the initiating material into the second buffer layer. Preferably the initiating material is phosphorus.

In this first embodiment of the invention, the implantation of the phosphorus will cause point defects to occur in the vicinity of the implantation. Subsequent annealing will cause both the phosphorus atoms and the point defects to migrate into the active layer, causing the desired modification of refractive index. It is believed that both the phosphorus atoms and the point defects contribute to the disordering of the quantum well(s) and their associated barrier layers, to give the desired refractive index modification.

In a second embodiment of the present invention, step (c) comprises selectively depositing the initiating material on the upper surface of the second buffer layer. Step (c) may further comprise selectively depositing a mask on the upper surface of the second buffer layer and then depositing the initiating material on the mask and the upper surface of the second buffer layer. Preferably, the initiating material is silica.

In this second embodiment of the invention, the sputtering causes a large number of point defects. Subsequent annealing will cause the point defects to migrate into the active layer, causing the desired disruption of the quantum wells.

Preferably the processing of the semiconductor laser in step (d) comprises thermally annealing the semiconductor laser. The method may comprise the additional step of (e) depositing further semiconductor material on the semiconductor laser.

The methods according to the present invention provide intermixing of the quantum wells of a DFB laser in a periodic fashion along the length of the laser, thus changing their bandgap, and providing modulation of gain without significantly increasing the optical loss of the laser and without a significant reduction device in device reliability or process yield.

According to a second aspect of the present invention there is a semiconductor laser manufactured by a method as described above.

The invention will now be described, by way of example only, with reference to the following Figures in which:
Figure 1 shows a schematic depiction of a first prior art technique;
Figure 2 shows a schematic depiction of a second prior art technique;
Figure 3 shows a schematic depiction of a method according to a first embodiment of the present invention; and
Figure 4 shows a schematic depiction of a method according to a second embodiment of the present invention.

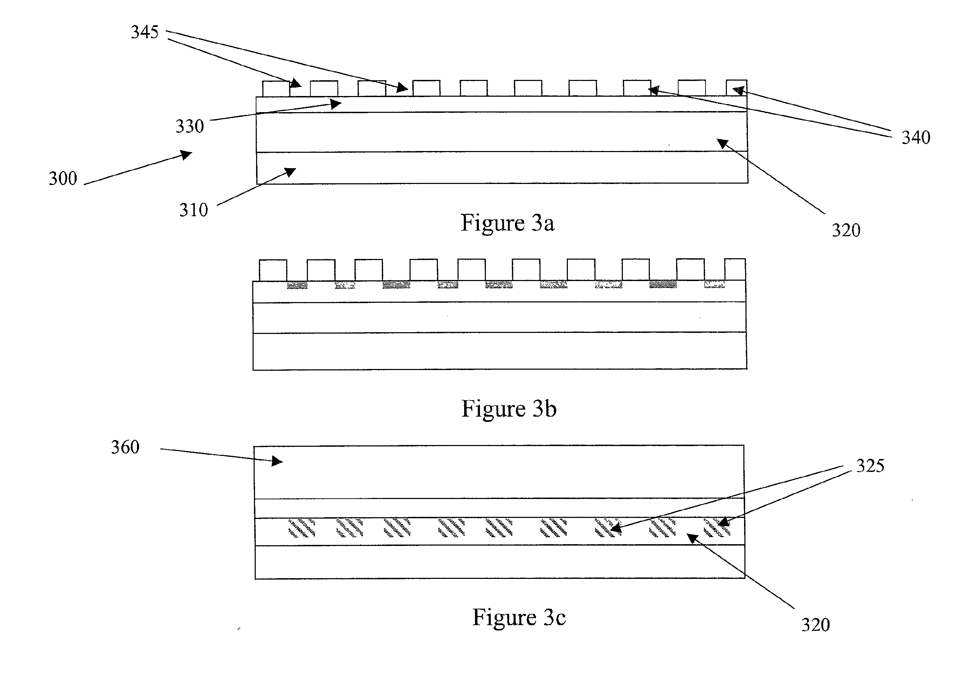

Figure 3 is a schematic depiction of a first embodiment according to the present invention. DFB laser structure 300 comprises an active layer 320 comprising one or more quantum wells. The active layer is typically 50 - 200 nm thick and is located above first buffer layer 310 and below second buffer layer 330. The active layer is typically a lightly doped or undoped III-V semiconductor material and comprises, in order to provide lasing in the 1.3µm to 1.6µm range, typically between 5 and 12 quantum wells having a bandgap of 1.2. to 1.5 microns, separated by barriers of a material having a wider bandgap. The quantum wells are conventionally strained by, for example, 0.5% to 1.5%. The barriers may also be strained, and possibly in the opposite direction to the strain in the quantum wells. The active layers may additionally comprise separate confinement layers located between the active layer and the two buffer layers, which form a part of the waveguide for optical and electrical confinement.

Photoresist regions 340 are formed on the upper surface of the second buffer layer 330 so as to leave a number of regions 345 where there is no photoresist . A further material is implanted into these upper buffer layer regions 345 without photoresist to a depth that is short of the active region (i.e. it is significantly less than the thickness of the second buffer layer 330). The amount of material that is to be deposited may be controlled in order to provide sufficient subsequent quantum well intermixing (see Figure 3b). The photoresist mask is stripped away before the structure is annealed, typically at a temperature in excess of 650C, and a waveguide overgrowth is formed on the structure (see Figure 3c). The annealing process causes the implanted material and defects associated with it to diffuse into the laser structure, causing the quantum layer(s) to intermix with the barrier layers. The rate and depth of intermixing will depend upon the initial implantation conditions and the temperature of the annealing process. The quantum well intermixing causes the refractive index to change and by appropriately choosing the sites at which the material is implanted the refractive index can be controlled so as to provide the desired gain modulation to form a gain-coupled DFB laser.

A suitable material for implantation within the laser is phosphorus, although other materials may also be used. The photoresist (or mask) may be used directly as a mask for the implantation species or may in turn be used to pattern an additional layer that can be used to provide more attenuation to the ion implantation process. An additional layer of material (not shown) may be used to protect the surface during the annealing process. Silicon oxide and silicon nitride are suitable materials that can be used in this way.

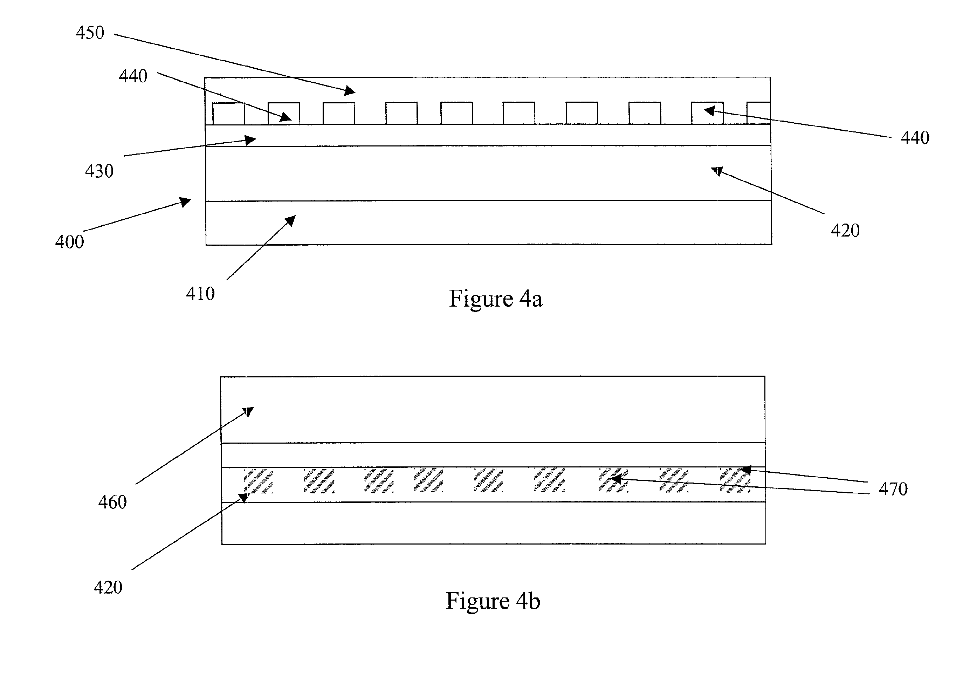

Figure 4 is a schematic depiction of a second embodiment according to the present invention. Semiconductor structure 400 comprises lower buffer layer 410, active layer 420 and upper buffer layer 430. A periodic pattern is formed on the upper surface of the upper buffer layer 430 using a silica layer deposited by sputter deposition (or a similar technique). The structure is annealed and this causes quantum well intermixing. The sputtering process provides a source of point defects which, if thermally annealed, cause quantum well intermixing within the active layer of the laser (this effect is commonly referred to as defect induced disordering). Appropriate patterning of the silica deposition can be used to provide the desired modulation of the refractive index within the laser to form a gain-coupled DFB laser.

Referring to Figure 4a, the silica is preferably patterned by first depositing a layer of silica using a low damage technique such as PECVD 440, then patterning this using conventional means, then covering with sputtered oxide 450. After the annealing process the silica layers are removed and the waveguide completed with a semiconductor overgrowth 460. The intermixed regions 470 are formed within the active layer 420. The silica may be patterned using conventional techniques, such as e-beam lithography or optical techniques such as holographic or lithographic techniques.

For both embodiments of the invention that are discussed above with reference to Figures 3 and 4, the composition of the first buffer layer 310, 410 is not critical to the working of the invention. Typically the buffer layer will be a III-V semiconductor material that comprises an n-type dopant with a dopant concentration of approximately 10¹⁸cm⁻³.

The second buffer layer 330, 430, typically comprises a binary, ternary or quaternary III-V semiconductor material (which may be the same material, or a similar material, as the other materials used in the device). The layers may be undoped, or have a p-type dopant with a concentration of approximately 10¹⁷cm⁻³.

The techniques used to overgrow the remaining structures are conventional and well known from the art. The only additional consideration is ensuring that the desired distribution of disordering is not changed by the additional processes, for example, annealing, etching, etc. If subsequent processing does cause the quantum well disordering to migrate further then the original distribution of disordering may be changed accordingly.

It will be clear to those skilled in the art that the above techniques can be applied to a wide range of semiconductor materials including, without limitation gallium, indium, arsenic, phosphorus, aluminium or tin, or combinations of these materials, and that they may be deposited upon substrates of InP or GaAs. The semiconductor materials may be suitably doped using known techniques and epitaxial layers of the semiconductor materials may be provided using MOVPE, MBE or other known methods.

## Claims

1. A method of producing a semiconductor laser (300, 400), the method comprising the steps of;
(a) forming an active layer (320, 420) on a first buffer layer (310, 410), the active layer comprising one or more quantum wells;
(b) forming a second buffer layer (330, 430) on the active layer; the method being **characterised by** the following steps
(c) selectively applying an initiating material to the semiconductor laser, the application of the initiating material inducing a plurality of damage effects; and
(d) processing the laser such that some of the initiating material or the damage effects migrate into the active layer so as to selectively modify the refractive index of the active layer.

2. A method according to claim 1, wherein during step (d) the migration of the initiating material or the damage effects modifies the refractive index of the active layer (320, 420) by disordering the one or more quantum wells.

3. A method according to claim 1 or claim 2, wherein step (c) comprises selectively implanting the initiating material into the second buffer layer (330).

4. A method according to step 3, wherein the initiating material is phosphorus.

5. A method according to claim 1 or claim 2, wherein step (c) comprises selectively depositing the initiating material on the upper surface of the second buffer layer (430).

6. A method according to claim 5, in which step (c) further comprises selectively depositing a mask (440) on the upper surface of the second buffer layer (430) and then depositing the initiating material (450) on the mask and the upper surface of the second buffer layer.

7. A method according to claim 5 or claim 6, wherein the initiating material is silica.

8. A method according to any preceding claim, wherein the processing of the semiconductor laser in step (d) comprises thermally annealing the semiconductor laser.

9. A method according to any preceding claim in which the method comprises the additional step of
(e) depositing further semiconductor material on the semiconductor laser.

10. A semiconductor laser produced by a method according to any preceding claim.
